# EUROPÄISCHE PATENTSCHRIFT

(11) **EP 3 209 104 B1**
(45) Veröffentlichungstag und Bekanntmachung des Hinweises auf die Patenterteilung: **06.04.2022**
(21) Anmeldenummer: 17156307.5
(22) Anmeldetag: 15.02.2017
(51) Int. Cl.: H05K 7/20

(54) **SCHALTSCHRANK**
CONTROL CABINET
ARMOIRE ÉLECTRIQUE

(30) Priorität: 17.02.2016 DE 102016102755
(43) Veröffentlichungstag der Anmeldung: 23.08.2017
(73) Patentinhaber: Bombardier Transportation GmbH, 10785 Berlin (DE)
(72) Erfinder: Friedrich, Ernst, 10245 Berlin (DE); Fretwurst, Mathias, 14612 Falkensee (DE)
(74) Vertreter: Zimmermann & Partner Patentanwälte mbB

(56) Entgegenhaltungen:
- CN-U- 204 090 339
- FR-A1- 2 942 442
- US-A1- 2015 216 078

## Beschreibung

### Technisches Gebiet

Die vorliegende Erfindung betrifft einen Schaltschrank zur Aufnahme von elektrischen und elektronischen Komponenten für ein Fahrzeug, insbesondere für ein Schienenfahrzeug. Weiterhin betrifft die Erfindung ein Fahrzeug mit einem solchen Schaltschrank. Ein derartiges Fahrzeug kann beispielsweise im öffentlichen Personennah- und Fernverkehr eingesetzt werden.

Ein solches Fahrzeug weist für gewöhnlich eine Reihe von elektrischen und elektronischen Komponenten auf. Diese dienen zum Beispiel dazu, Funktionen des Fahrbetriebs, eine Betriebsüberwachung, Kommunikation und/oder Konditionierung der Luft im Innenraum zu ermöglichen. Die dazu notwendigen Komponenten sind in einem Schaltschrank gesammelt aufgenommen, wo diese mit Signalleitungen verbunden sind und mit elektrischer Energie versorgt werden, bzw. den Energiefluss von und zu Energie verbrauchenden Bauteilen steuern.

### Vorbekannter Stand der Technik

Im Allgemeinen ist bekannt, dass Schaltschränke in Fahrzeugen, insbesondere in Schienenfahrzeugen, derart im Fahrzeuginnenraum angeordnet sind, sodass ein Zugang zu den im Schaltschrank befindlichen Komponenten aus dem Fahrzeuginnenraum über eine Klappe oder Schaltschranktür gewährleistet wird.

Da ein solcher Schaltschrank meist elektrische oder elektronische Komponenten aufnimmt, ist Vorsorge zum Abtransport der davon produzierten Wärmeenergie zu treffen, um einer unzulässigen Erwärmung des Innenraums des Schaltschranks vorzubeugen. Meist sind dazu geeignete Öffnungen zur Belüftung bzw. zum Austausch der Luft des Innenraums des Schaltschranks vorgesehen.

Aus der deutschen Patentschrift DE 103 308 749 B4 ist ein Schaltschrank für papierverarbeitende Maschinen bekannt, wobei im Inneren des Schaltschranks ein elektrisches Leistungsbauteil auf einer Leiterplatte verbaut ist. Um das Leistungsbauteil vor Überhitzung zu schützen, ist dieses wärmeleitend mit wenigstens einem Kühlkörper verbunden, wobei die wärmeleitende Verbindung flächig ausgeführt ist. Die vom Leistungsbauteil erzeugte Wärme wird somit über einen Wärmeleiter direkt aus dem Inneren des Schaltschranks abgeführt und über den Kühlkörper an einer Außenseite des Schaltschranks an die Umgebung abgegeben.

Weiterhin ist in der DE 10 2011 118 439 A1 ein Schaltschrank offenbart, welcher zum Steuern einer Textilmaschine dient. Der Schaltschrank weist dabei einen Raum mit einem elektronischen Bauelement und einen zweiten Raum mit einem Kühlkörper auf. Das elektronische Bauelement ist mit dem Kühlkörper wärmeleitend verbunden, wodurch ein Wärmetransport aus dem ersten Raum in den zweiten Raum ermöglicht wird. Weiterhin ist zwischen dem ersten Raum und dem zweiten Raum eine Klappe vorgesehen, durch welche mittels eines Ventilators Kühlluft aus dem zweiten Raum in den ersten Raum eingeblasen werden kann. Die US 2015 02 16 078 A1 offenbart einen elektrischen Schaltschrank, der ein elektrisches und elektronisches Gerät zum Betreiben und Steuern von Elektromotoren einer Industrieanlage enthält. Der Schaltschrank enthält eine Kühlvorrichtung mit einem ersten Wärmetauscher, der mit einem ersten Satz von Kanälen angeordnet ist, durch die ein erster Luftstrom aus dem Inneren des Elektroraums geleitet wird. Ein weiterer Schaltschrank ist aus CN 204 090 339 U vorbekannt.

### Nachteile des Standes der Technik

Die bisher bekannten Lösungen sind nur eingeschränkt in der Lage große Mengen erzeugter Wärme aus einem Schaltschrank abzuführen. Weiterhin besteht die Gefahr, dass im Schaltschrank befindliche, empfindliche elektronische Bauteile durch die Ausprägung der Kühlung nach dem Stand der Technik hinsichtlich ihrer Lebensdauer und Funktionsintegrität negativ beeinflusst werden.

### Problemstellung

Aufgabe der vorliegenden Erfindung ist es daher, einen Schaltschrank für ein Fahrzeug, insbesondere für ein Schienenfahrzeug, und ein Fahrzeug mit einem solchen Schaltschrank bereitzustellen. Es soll gleichzeitig bei einem einfachen und robusten Aufbau des Schaltschranks ein effizienter und ausreichend hoher Wärmeabtransport aus dem Schaltschrank und eine hohe Lebensdauer der im Schaltschrank befindlichen Komponenten ermöglicht werden.

### Erfindungsgemäße Lösung

Die obige Aufgabe wird durch einen Schaltschrank nach Anspruch 1 oder durch ein Schienenfahrzeug nach Anspruch 12 gelöst. Weitere Ausführungsformen der Erfindung werden anhand der abhängigen Ansprüche bereitgestellt.

Der Schaltschrank weist einen Innenraum zur Aufnahme mindestens einer Wärme erzeugenden Komponente auf. Dazu können im Innenraum gegebenenfalls Träger oder Einschubregale ausgebildet sein, an welchen die Komponente vorzugsweise lösbar befestigt werden kann. Als Innenraum des Schaltschranks gilt insbesondere der innere Bereich des Schaltschranks, in welchem elektrische und elektronische Komponenten verbaut werden können. Der gesamte Schaltschrank kann ein abgeschlossenes Gehäuse aufweisen, welches zum Beispiel aus flächigem Blech oder Kunststoff hergestellt wird. Der Innenraum zur Aufnahme von Komponenten kann somit zumindest teilweise von einem äußeren Gehäuse des Schaltschranks gebildet werden.

Weiterhin ist in dem Schaltschrank eine Primärkühlvorrichtung vorgesehen, welche einen Einlass, einen sich daran anschließenden Kühlkanal, eine im Bereich des Kühlkanals angeordnete Wärmesenke und einen Auslass umfasst. Einlass und Auslass sind strömungstechnisch mit dem Innenraum verbunden, sodass die Primärkühlvorrichtung und der Innenraum einen in sich geschlossenen Primärkühlkreislauf bilden. Vorzugsweise dient die im Innenraum und in der Primärkühlvorrichtung vorhandene Luft als Kühlmedium.

Wird das im Innenraum befindliche Kühlmedium durch die Wärme erzeugende Komponente erwärmt so gelangt es - gegebenenfalls unter Verwendung einer Zwangsbelüftung - in den Einlass der Primärkühlvorrichtung und durchströmt den Kühlkanal. Darin gibt die erwärmte Luft Wärmeenergie an die im Kühlkanal angeordnete Wärmesenke ab und gelangt darauf folgend wieder in den Innenraum des Schaltschranks.

Weiterhin weist der Schaltschrank eine Sekundärkühlvorrichtung mit einer Einströmöffnung, einer Ausströmöffnung und mit einem die Öffnungen verbindender Strömungskanal auf, wobei im Strömungskanal eine Wärmequelle angeordnet ist. Gemäß einer Ausführungsform ist die Sekundärkühlvorrichtung zumindest teilweise oder vollständig innerhalb des Gehäuses des Schaltschranks angeordnet.

Die Wärmesenke des Primärkühlkreislaufs ist mit der Wärmequelle des Sekundärkühlkreislaufs zum Übertragen von Wärme von der Wärmesenke auf die Wärmequelle geeignet verbunden. Dadurch bilden die Wärmesenke und die Wärmequelle hinsichtlich ihrer kombinierten Funktion einen Wärmetauscher, der wirksam zwischen dem Primärkühlkreislauf und dem Sekundärkühlkreislauf angeordnet ist.

Gemäß einer Ausführungsform ist der Primärkühlkreislauf stofflich im Wesentlichen von einer ihn umfassenden Umgebung getrennt, sodass das Kühlmedium des Primärkühlkreislaufs nicht in die Umgebung ausströmen kann oder in der Umgebung befindliche Gegenstände und gasförmige oder flüssige Fluide nicht in den Primärkühlkreislauf und damit in den Innenraum des Schaltschranks gelangen können.

Gemäß einer weiteren Ausgestaltung sind der Primärkühlkreislauf und der Sekundärkühlkreislauf bzw. die Primärkühlvorrichtung und die Sekundärkühlvorrichtung stofflich vollständig voneinander getrennt gestaltet. Somit ist es dem Kühlmedium in der Primärkühlvorrichtung bzw. in der Sekundärkühlvorrichtung nicht möglich, in den Sekundärkühlkreislauf der Sekundärkühlvorrichtung bzw. in den Primärkühlkreislauf der Primärkühlvorrichtung überzutreten.

Der beschriebene Schaltschrank umfasst also einen Innenraum, woraus mittels der Primärkühlvorrichtung Wärme abgeführt und unter Verwendung des Wärmetauschers in das Kühlmedium des Sekundärkühlkreislaufs eingetragen werden kann. Es wird dabei gemäß einer Ausführungsform sichergestellt, dass der Innenraum und der Primärkühlkreislauf hermetisch von der Umgebung abgetrennt sind, gleichzeitig wird jedoch eine effektive Kühlung der im Innenraum befindlichen Komponenten ermöglicht. Die im Innenraum erzeugte Wärme wird über den Wärmetauscher an das in der Sekundärkühlvorrichtung befindliche Kühlmedium, zum Beispiel Luft, übertragen und abtransportiert.

Besonders vorteilhaft zeigt sich die Verwendung des beschriebenen Schaltschranks in einem Fahrzeug größerer Dimension. Ein solches Fahrzeug kann beispielsweise ein Bus, ein Schienenfahrzeug, ein Waggon oder eine Lokomotive eines Schienenfahrzeugs, ein aus mehreren Waggons oder Triebfahrzeugen bestehender Zug oder ein Luftfahrzeug zum Transport von einer großen Anzahl von Personen, ein Fahrzeug zum Transport von großen Lasten, zum Beispiel ein Lastkraftwagen, ein Cargoflugzeug oder ein Güterwaggon sein.

Den beschriebenen Fahrzeugen wohnt es inne, dass diese die Dimensionen eines PKWs um ein Vielfaches überschreiten und eine hohe Anzahl von Wärme erzeugenden, insbesondere elektrischen Komponenten aufweisen. Diese Komponenten werden gebündelt in einem oder wenigen Schaltschränken angesiedelt, wodurch diese Komponenten zentral mit Energie versorgt und Signalverbindungen verbunden werden können. Der erfindungsgemäße Schaltschrank erweist sich hierzu als besonders geeignet, da mit einem solchen sichergestellt werden kann, dass die teilweise empfindlichen Komponenten nicht durch Materie aus der Umgebung beschädigt oder verschmutzt werden (Mikropartikel, Staub, etc.), und gleichzeitig eine große Menge von Abwärme aus dem Innenraum des Schaltschranks abgeführt werden kann. Da die besagten Fahrzeuge sich naturgemäß in unterschiedlichen Umgebungen aufhalten, ist die Verwendung eines erfindungsgemäßen Schaltschranks bzw. einer Ausführungsform dessen mit einem abgedichtet Innenraum besonders sinnvoll.

Gemäß einer weiteren Ausgestaltung ist der Primärkühlkreislauf derart ausgebildet, dass die im Innenraum des Schaltschranks anzuordnenden Komponenten von dem Kühlmedium gleichmäßig umströmt werden. Dies hat zur Folge, dass die Kühlung aller vorhandenen Komponenten gleichmäßig und ausreichend erfolgt.

Gemäß einer Ausführungsform sind die Wärmesenke und die Wärmequelle körperlich miteinander verbunden. Denkbar ist, dass der somit gebildete Wärmetauscher von zwei direkt miteinander über eine Kontaktfläche verbundenen Einzelbauteilen gebildet wird. Um die Wärmeleitung aus der Wärmesenke in die Wärmequelle über die Kontaktflächen optimal zu gestalten, kann eine Wärmeleitpaste zwischen den Kontaktflächen der Einzelbauteile vorgesehen sein.

Gemäß einer alternativen Ausführungsform ist der Wärmetauscher einstückig aus einem einzigen Material hergestellt, insbesondere aus einem Gusswerkstoff mit einer hohen Wärmeleitzahl, zum Beispiel mit einer Wärmeleitzahl größer 50, insbesondere größer 200 und besonders bevorzugt größer 300 W/(m . K). Weiterhin ist auch denkbar, den Wärmetauscher aus Aluminium, insbesondere aus einem Aluminium-Strangpressprofil mit den oben genannten Wärmeleiteigenschaften, zu fertigen.

Gemäß einer Ausführungsform kann der Gusswerkstoff des Wärmetauschers zu einem nicht unerheblichen Teil aus Kupfer bestehen.

Gemäß einer weiteren alternativen Ausführungsform sind die Wärmesenke und die Wärmequelle nicht direkt aneinander angrenzend vorgesehen, sondern an unterschiedlichen Orten angeordnet. Um einen Transport von Wärmeenergie von der Wärmesenke zur Wärmequelle zu ermöglichen, sind geeignete Übertragungsmittel zwischen Wärmesenke und Wärmequelle vorzusehen, denkbar dafür sind zum Beispiel Strukturen, welche aus einem Werkstoff mit einer hohen Wärmeleitzahl hergestellt sind, zum Beispiel Kupferstangen.

Gemäß einer Ausgestaltung kann der Wärmetauscher eine zweiseitige Rippen- oder Zackenstruktur aufweisen, wobei eine erste Seite als Wärmesenke und eine zweite Seite als Wärmequelle dient.

Weiterhin ist es möglich, dass der Wärmetauscher als räumlich trennendes Element zwischen dem Kühlkanal der Primärkühlvorrichtung und dem Strömungskanal der Sekundärkühlvorrichtung vorgesehen ist. Somit sind Primärkühlkreislauf und Sekundärkühlkreislauf stofflich voneinander getrennt, jedoch hinsichtlich des Wärmeübergangs über den Wärmetauscher miteinander verbunden. Auf diese Weise wird ein besonders effizienter Wärmetransport aus dem Primärkühlkreislauf in den Sekundärkühlkreislauf ermöglicht.

Gemäß der oben genannten Ausführungsform kann sich die erste Seite der zweiseitigen Rippen- oder Zackenstruktur in den Kühlkanal der Primärkühlvorrichtung und die zweite Seite in den Strömungskanal der Sekundärkühlvorrichtung erstrecken.

Denkbar ist, dass die Rippen des Wärmetauschers im Wesentlichen parallel zur Strömungsrichtung des Kühlmediums im Kühlkanal und/oder im Strömungskanal ausgerichtet sind.

Im Rahmen einer weiteren Ausführungsform wird offenbart, dass der Kühlkanal des Primärkühlkreislaufs und der Strömungskanal des Sekundärkühlkreislaufs direkt aneinander angrenzend angeordnet sind. Dazu kann sich der Wärmetauscher in einer Längsrichtung des Schaltschranks über mindestens 50 %, bevorzugt 70 % und besonders bevorzugt über 85 % der Länge des Kühlkanals der Primärkühlvorrichtung erstrecken. Die Längsrichtung ist hierbei im Wesentlichen parallel zur HauptStrömungsrichtung durch den Kühlkanal orientiert. Die oben genannte Ausprägung hat zur Wirkung, dass das Kühlmedium des Primärkühlkreislaufs über eine möglichst große Oberfläche des Wärmetauschers strömt, und somit ein effektiver Wärmeübergang ermöglicht wird.

Bezüglich einer Montage- oder Aufstellposition des Schaltschranks ist die Längsrichtung in Richtung der Höhenausprägung des Schaltschranks zu definieren.

Weiterhin ist es möglich, dass der Wärmetauscher sich über die gesamte Breite des Kühlkanals des Primärkühlkreislaufs und/oder die gesamte Breite des Strömungskanals des Sekundärkühlkreislaufs erstreckt. Die hierbei genannte Breite orientiert sich an einer Querrichtung des Schaltschranks, welche wiederum im Wesentlichen senkrecht zur Strömungsrichtung der Kühlmedien durch den Kühlkanal bzw. durch den Strömungskanal ausgerichtet ist.

Um die Zirkulation des Kühlmediums im Primärkreislauf zu verbessern, wird erfindungsgemäß vorgeschlagen, dass die Primärkühlvorrichtung eine Lüftereinheit zum Umwälzen des Kühlmediums umfasst. Diese ist im Bereich des Auslasses vorgesehen, wodurch Luft aus dem Innenraum durch den Kühlkanal angesaugt und via den Auslass wieder zurück in den Innenraum geblasen wird. Dadurch erhöht sich die Wahrscheinlichkeit, dass sich im Innenraum mannigfaltige, insbesondere turbulente Strömungsformen des Kühlmediums ausbilden, wodurch eine gleichmäßige Kühlung aller im Innenraum vorhandenen Komponenten ermöglicht wird.

Gemäß einer Ausgestaltung weist der Schaltschrank ein von der Außenseite des Schaltschranks zugängliches Einschubfach zum Aufnehmen der Lüftereinheit auf. Die Zugänglichkeit zu dem Einschubfach kann entweder über eine bereits vorhandene Tür des Schaltschranks oder durch eine in dem Gehäuse des Schaltschranks vorgesehene Zugangsklappe oder Deckel erfolgen. Die genannte Schaltschranktür dient gegebenenfalls auch dazu, den Innenraum des Schaltschranks zu Zwecken der Wartung oder zum Austausch von Komponenten zugänglich zu machen. Die einfache Zugänglichkeit des Einschubfachs der Lüftereinheit ermöglicht einen schnellen und einfachen Austausch der selbigen.

Denkbar ist, dass zwischen einer Wandung des Gehäuses des Schaltschranks und der Tür des Schaltschranks Dichtelemente zum Abdichten des Innenraums gegenüber der Umgebung vorgesehen sind.

Gemäß einer weiteren Ausführungsform umfasst die Sekundärkühlvorrichtung ein Gebläse, welches derart angeordnet ist, dass die Wärmequelle bzw. der Teil des Wärmetauschers im Strömungskanal der Sekundärkühlvorrichtung ausreichend umströmt wird, und ein Abtransport der im Primärkreislauf in den Wärmetauscher eingetragenen Wärme sichergestellt wird.

Gemäß einer Ausgestaltung ist das Gebläse stromaufwärts der Einströmöffnung, insbesondere in deren unmittelbarer Umgebung, vorgesehen. Somit erzeugt das Gebläse gegenüber der Umgebung einen Überdruck im Strömungskanal.

Der Sekundärkühlkreislauf kann als offener Kühlkreislauf ausgebildet sein. Dazu sind die Einströmöffnung und die Ausströmöffnung der Sekundärkühlvorrichtung strömungstechnisch mit einer Umgebung des Schaltschranks verbunden. Dadurch kann Umgebungsluft in die Einströmöffnung der Sekundärkühlvorrichtung einfließen, durch den Strömungskanal über die Oberfläche der Wärmequelle bzw. des Wärmetauschers streichen und im Folgenden über die Ausströmöffnung in die Umgebung entweichen.

Um ein Zusetzen des Wärmetauschers im Strömungskanal zu verhindern oder zu verlangsamen, wird gemäß einer Ausführungsform vorgeschlagen, eine Filtervorrichtung wirksam stromaufwärts der Einströmöffnung, insbesondere in deren unmittelbarer Umgebung, anzuordnen. Dies erscheint insbesondere im Hinblick darauf vorteilhaft, wenn der Sekundärkühlkreislauf als offener Kreislauf gestaltet ist, und somit in der Umgebung befindliche Partikel, Gegenstände oder Flüssigkeiten in die Einströmöffnung der Sekundärkühlvorrichtung gelangen könnten.

Im Rahmen einer weiteren, optionalen Ausführungsform wird angegeben, dass an einer geeigneten Stelle des Primärkühlkreislaufs eine weitere Filtervorrichtung vorgesehen ist. Durch eine solche kann im Innenraum oder in der primären Kühlvorrichtung vorhandener Staub zentral gesammelt, und ein Ablegen dessen auf elektrischen oder elektronischen Komponenten im Innenraum des Schaltschranks verhindert werden.

Gemäß einer Ausführungsform des Schaltschranks kann die Sekundärkühlvorrichtung flächig an einer Rückseite des Schaltschranks ausgebildet sein.

Im Rahmen einer weiteren Ausgestaltung ist der Strömungskanal mittels einer demontierbare Abdeckung, insbesondere an der Rückseite des Schaltschranks, von der Umgebung abgetrennt. Um den Wärmetauscher im Strömungskanal zu reinigen, kann somit die gesamte Abdeckung bzw. die Rückseite des Schaltschranks abgenommen werden, wodurch die Wärmequelle des Wärmetauschers großflächig zugänglich wird. Dadurch erhöht sich die Wartungsfreundlichkeit des Schaltschranks, da eine Reinigung des Wärmetauschers in kurzer Zeit erfolgen kann.

Gemäß einer Ausführungsform der Erfindung ist die Primärkühlvorrichtung derart ausgebildet, dass - bezüglich einer Montage- oder Aufstellposition des Schaltschranks - das Kühlmedium bei Erwärmung im Innenraum von unten nach oben aufsteigt und dann an einer oberen Seite des Innenraums in den Einlass der Primärkühlvorrichtung gelangt. Von dort aus führt der Kühlkanal im Schaltschrank von oben nach unten, wobei das Kühlmedium abgekühlt, indem es seine Wärmeenergie an der Wärmesenke des Wärmetauschers abgibt. Der Auslass der Primärkühlvorrichtung ist in einem unteren Bereich des Schaltschranks vorgesehen, sodass der Innenraum in einem unteren Bereich von dem Kühlmedium beaufschlagt wird. Diese Ausprägung bewirkt, dass sich gemäß einer Ausgestaltung der Erfindung eine selbst-zirkulierende Strömung des Kühlmediums ausbildet.

Im Rahmen einer weiteren Ausführungsform wird angegeben, dass - bezüglich einer Montage- oder auf der Position des Schaltschranks - das Kühlmedium der Sekundärkühlvorrichtung beim Überströmen des Wärmetauschers im Strömungskanal im Wesentlichen von einem unteren Bereich des Schaltschranks in einen oberen Bereich des Schaltschranks gelangt. Durch diese Ausprägung kann eine Eigenzirkulation des Sekundärkühlkreislaufs erreicht werden.

Durch Kombination der beiden voranstehenden Ausführungsformen wird eine besonders vorteilhafte, energiesparende und gegebenenfalls selbstregelnde Ausgestaltung der Strömungen des Kühlmediums im Primärkühlkreislauf und im Sekundärkühlkreislauf ermöglicht. Bei Erwärmung des Innenraums des Schaltschranks beginnt das Kühlmedium des Primärkühlkreislaufs zu zirkulieren und Wärme in den Wärmetauscher einzutragen. Aufgrund der Erwärmung der Wärmequelle des Wärmetauschers wird das im Strömungskanal befindliche Kühlmedium angewärmt, wodurch es nach oben aufsteigt. Im Folgenden wird frisches Kühlmedium durch die Einströmöffnung angesaugt.

Im Rahmen einer weiteren Ausgestaltung wird offenbart, dass der Primärkühlkreislauf und der Sekundärkühlkreislauf, die Dimension des Wärmetauschers, die Quantität der Wärmequellen im Innenraum und die Volumina der Kühlmedien derart aufeinander abgestimmt sind, sodass in der Primärkühlvorrichtung und/oder in der Sekundärkühlvorrichtung keine Lüftereinheit und/oder Gebläse vorgesehen sind. Bei einer derartigen Ausprägung des Schaltschranks sind der Primärkühlkreislauf und/oder der Sekundärkühlkreislauf selbstregelnd mit selbst-zirkulierenden Strömungen ausgestattet.

Im Rahmen der Erfindung wird ein Fahrzeug, insbesondere ein Schienenfahrzeug, offenbart welches einen Wagenkasten mit einem Fahrgastraum und mindestens einen Schaltschrank gemäß einer oder mehrerer der voran genannten Ausführungsformen aufweist. Der Schaltschrank kann dabei derart im Schienenfahrzeug angeordnet sein, sodass dieser vom Innenraum oder von einer Außenseite des Fahrzeugs erreichbar ist. Dazu weist der Schaltschrank in geeigneter Weise eine Tür oder eine Klappenvorrichtung auf.

Gemäß einer weiteren Ausgestaltung ist/sind dabei die Einströmöffnung der Sekundärkühlvorrichtung des Schaltschranks und/oder die Ausströmöffnung mit einer Außenumgebung des Wagenkastens verbunden. Dadurch wird Kühlluft von außen der Sekundärkühlvorrichtung zugeführt und nach Erwärmung wiederum in die Umgebung abgegeben.

Gemäß einer alternativen Ausgestaltung ist/sind die Einströmöffnung und/oder die Ausströmöffnung mit dem Fahrgastraum des Fahrzeugs verbunden. Auf diese Weise kann die Abwärme des Schaltschranks zum Erwärmen des Innenraums des Fahrzeugs verwendet werden.

Der Schaltschrank ist gemäß einer Ausführungsform derart im Wagenkasten vorgesehen, sodass die Sekundärkühlvorrichtung zwischen dem Innenraum des Schaltschranks und einer Außenwand des Wagenkastens verläuft. Auf diese Weise ist es möglich, dass die Sekundärkühlvorrichtung in ihrer Gesamtheit über die Außenwand des Wagenkastens gekühlt wird.

Gemäß einer alternativen Ausführungsform verläuft die Sekundärkühlvorrichtung zwischen dem Innenraum des Schaltschranks und dem Fahrgastraum. Somit kann die Sekundärkühlvorrichtung zur Erwärmung einer Innenwand des Fahrgastraums beitragen.

Die vorstehend beschriebenen Ausführungsformen können beliebig, jedoch in sinnhafter Weise miteinander kombiniert werden.

### Kurzbeschreibung der Figuren

Die beiliegenden Zeichnungen veranschaulichen Ausführungsformen und dienen zusammen mit der Beschreibung der Erläuterung der Prinzipien der Erfindung. Die Elemente der Zeichnungen sind relativ zueinander und nicht notwendigerweise maßstabsgetreu.

Gleiche Bezugszeichen bezeichnen gleiche oder entsprechend ähnliche Teile.
Fig. 1 zeigt ein Schienenfahrzeug mit einem Schaltschrank,
Fig. 2 führt einen Querschnitt durch einen Wärmetauscher des Schaltschranks gemäß Fig. 1 an,
Fig. 3 zeigt die Lüftereinheit der Primärkühlvorrichtung des Schaltschranks gemäß Fig. 1,
Fig. 4 zeigt einen schematischen Längsschnitt des Schaltschranks gemäß Fig. 1,
Fig. 5 einen Querschnitt des Schienenfahrzeugs gemäß Fig. 1, und
Fig. 6 ein Längsschnitt einer weiteren Ausführungsform eines Schienenfahrzeugs mit einem Schaltschrank.

### Ausführungsbeispiele

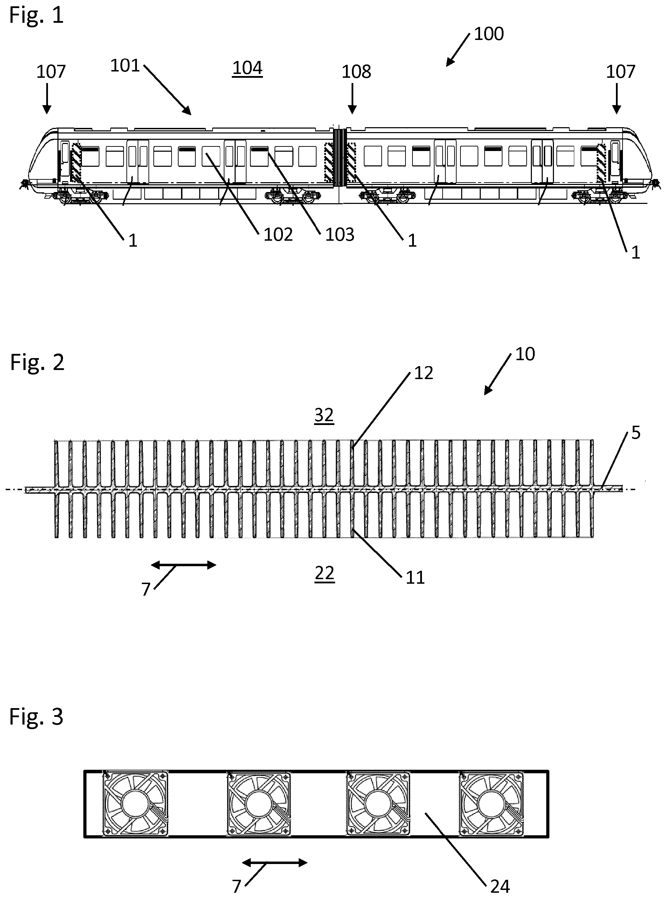

Zur Verdeutlichung des Gesamtzusammenhangs wird anhand Fig. 1 ein Schienenfahrzeug 100 dargestellt. Dieses umfasst wie gezeigt zwei Einzel-Schienenfahrzeuge bzw. zwei aneinandergekoppelte Passagierwaggons mit jeweils einem Wagenkasten 101.

Das Schienenfahrzeug 100 bzw. ein Waggon des Schienenfahrzeugs 100 weist mehrere Schaltschränke 1 auf, welche jeweils in einem vorderen Bereich eines Führerstands 107 und in einem hinteren Bereich einer Wagenkupplung 108 angeordnet sind. Denkbar ist, dass in dem Schaltschrank 1 im Bereich des Führerstands 107 Steuerungseinheiten und weitere elektrische und/oder elektronische Komponenten zum Bereitstellen von Kommunikations- und Fahrbetriebsfunktionen vorgesehen sind. In dem Schaltschrank 1 im Bereich der Wagenkupplung 108 können zum Beispiel Komponenten zur Steuerung und Regelung einer Klimaanlage angeordnet sein. In diesem Zusammenhang kann der Schaltschrank 1 mit Türen oder Klappen versehen sein, sodass dieser aus dem Inneren des Führerstands 107 bzw. aus dem Fahrgastraum 102 des jeweiligen Wagenkastens 101 zugänglich ist.

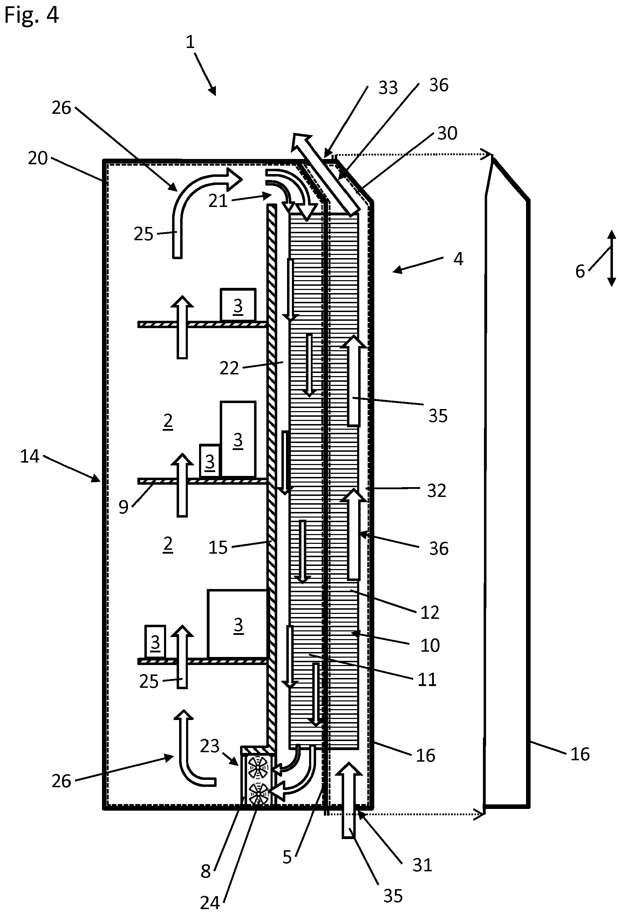

Anhand Fig. 4 wird ein exemplarisches Ausführungsbeispiel eines Schaltschranks 1 in einem Längsschnitt dargestellt. Die Außenstruktur des Schaltschranks 1 wird im Wesentlichen durch ein Gehäuse 14 gebildet. Der Innenraum 2 ist durch einen Teil des Gehäuses 14 und durch das Trennelement 15 begrenzt. Um den Innenraum 2, zum Beispiel für Wartungszwecke, zugänglich zu machen, ist im Gehäuse 14 eine nicht dargestellte Zugangsklappe oder Tür geeignet vorgesehen.

Das Gehäuse 14 und/oder das Trennelement 15 sind im Bereich des Innenraums 2 derart ausgebildet, dass daran eine Wärme erzeugende Komponente 3 befestigt werden kann, zum Beispiel mithilfe von Trägern 9. Weiterhin können auch geeignete Einschubfächer oder Regalvorrichtungen zum Tragen von Wärme erzeugenden oder anderen Komponenten 3 an dem Gehäuse 14 und/oder an dem Trennelement 15 vorgesehen sein.

Auf der dem Innenraum 2 abgewandten Seite des Trennelements 15 schließt sich eine Primärkühlvorrichtung 20 an, wobei ein Kühlkanal 22 der Primärkühlvorrichtung 20 über einen Einlass 21 und einen Auslass 23 strömungstechnisch mit dem Innenraum 2 verbunden ist. Der Kühlkanal 22 wird durch das Trennelement 15, durch eine sich anschließende Trennwand 5 und durch das Gehäuse 14 gebildet. In der Trennwand 5 ist ein Wärmetauscher 10 vorgesehen, insbesondere kann die Trennwand 5 zu einem Teil oder vollständig durch den Wärmetauscher 10 gebildet sein, welcher eine Wärmesenke 11 und eine Wärmequelle 12 aufweist. Der Wärmetauscher 10 ist so in der Trennwand 5 vorgesehen oder als Trennwand 5 ausgebildet, dass die Wärmesenke 11 in den Kühlkanal 22 ragt. Vorzugsweise ist die Wärmesenke 11 mit Kühlrippen ausgebildet, welche im Wesentlichen längs zur Hauptströmungsrichtung des Kühlkanals 22 verlaufen (Fig. 2).

Die andere Seite des Wärmetauschers 10 ragt auf der dem Kühlkanal 22 abgewandten Seite der Trennwand 5 in einen Strömungskanal 32 einer Sekundärkühlvorrichtung 30 hinein und bildet dort eine zu kühlende Wärmequelle 12.

Bezüglich einer Montage- oder Aufstellposition des Schaltschranks 1 ist der Innenraum 2, das Trennelement 15, der Einlass 21, der Auslass 23, der Kühlkanal 22, das Gehäuse 14 und die Trennwand 5 derart ausgeprägt, dass die im Innenraum 2 befindliche Luft 25 von den Komponenten 3 erwärmt werden kann und infolgedessen in einen oberen Bereich des Schaltschranks 1 aufsteigt. Dort tritt die Luft 25 über den Einlass 21 in die Primärkühlvorrichtung 20 ein und überstreicht die Wärmesenke 11 des Wärmetauschers 10. Aufgrund der damit verbundenen Abkühlung der Luft 25 fällt diese herab und gelangt über den Auslass 23 wieder in den Innenraum 2.

Insbesondere können das Gehäuse 14 und die Trennwand 5 - insbesondere unter Verwendung von nicht dargestellten Dichtmitteln - so zusammenwirkend ausgebildet sein, dass das Volumen von Innenraum 2 und Primärkühlvorrichtung 20, bzw. das Volumen des Primärkühlkreislaufs 26 gegenüber der Umgebung abgedichtet ist. Somit sind die Komponenten 3 im Innenraum 2 gegen externe Verschmutzung geschützt.

Gemäß Fig. 4 ist im Bereich des Auslasses 23 der Primärkühlvorrichtung 20 eine Lüftereinheit 24 vorgesehen. Diese saugt die Luft 25 durch den Kühlkanal 22 und pumpt diese in den Innenraum 2. Die in Fig. 4 mittels Pfeile dargestellte Zirkulation des geschlossenen Primärkühlkreislaufs 26 wird somit zumindest teilweise durch die Lüftereinheit 24 mitverursacht.

Das Einblasen von Luft 25 in den Innenraum 2 verstärkt die Wirkung, sämtliche Wärme erzeugende Komponenten 3 ausreichend, insbesondere durch Ausbildung von Turbulenzen, zu umströmen. Die Gefahr einer Entstehung von Toträumen ohne ausreichende Zirkulation und Anströmung, und folglich ohne ausreichende Kühlung wird somit verringert.

Weiterhin weist das Gehäuse 14 des Schaltschranks 1 auf der dem Innenraum 2 abgewandten Seite der Trennwand 5 eine Abdeckung 16 auf. Diese ist derart vorgesehen, sodass Abdeckung 16 und Trennwand 5 einen Zwischenraum begrenzen, welcher als Strömungskanal 32 der Sekundärkühlvorrichtung 30 dient. Die Abdeckung 16 weist - bezüglich der Montage- bzw. Aufstellposition des Schaltschranks 1 - an einem unteren Bereich eine Einströmöffnung 31 und an einem oberen Bereich eine Ausströmöffnung 33 auf. Somit ist die Sekundärkühlvorrichtung 30 gegenüber der Umgebung des Schaltschranks 1 offen und wird im Wesentlichen durch die Trennwand 5, die Abdeckung 16 und die Ein- und Ausströmöffnungen 31 und 33 gebildet. Die Sekundärkühlvorrichtung 30 dient dazu, die in den Strömungskanal 32 ragende Wärmequelle 12 des Wärmetauschers 10 durch Umströmen mit einem Kühlmedium, insbesondere durch Kühlluft 35, zu kühlen.

Die Sekundärkühlvorrichtung 30 wird dabei derart durch die Abdeckung 16 des Gehäuses 14 und die Trennwand 5 geformt, sodass im aufgestellten oder montierten Zustand des Schaltschranks 1 die Kühlluft 35 an einer Unterseite des Schaltschranks 1 durch die Einströmöffnung 31 in den Strömungskanal 32 einströmt. Dort angelangt, wird die Kühlluft 35 von der Wärmequelle 12 des Wärmetauschers 10 erwärmt, steigt durch die Erwärmung im Folgenden nach oben und entweicht letztendlich durch die Ausströmöffnung 33 in die Umgebung oder in weitere hier nicht dargestellte Luftkanäle.

Wie in dem Querschnitt des Wärmetauschers 10 in Fig. 2 dargestellt, kann die Wärmequelle 12 des Wärmetauschers 10 beispielsweise Rippen umfassen. Diese verlaufen gemäß einer Ausführungsform im Wesentlichen parallel zur Strömungsrichtung der Kühlluft 35 durch den Strömungskanal 32. Anhand der Fig. 2 wird deutlich, dass der Wärmetauscher 10 gleichzeitig die Trennwand 5 bildet und somit den Kühlkanal 22 stofflich gegenüber dem Strömungskanal 32 abtrennt. Die Kühlrippen der Wärmesenke 11 ragen dabei in den Kühlkanal 22 der Primärkühlvorrichtung 20 und die Rippen der Wärmequelle 12 in den Strömungskanal 32 der Sekundärkühlvorrichtung 30 hinein.

Anhand der in Fig. 4 nach rechts versetzten Abdeckung 16 (gestrichelte Pfeile) soll der geöffnete Zustand der Sekundärkühlvorrichtung 30 bzw. des Strömungskanals 32 verdeutlicht werden. Indem die Abdeckung 16 großflächig von der Rückseite 4 des Schaltschranks 1 abgenommen werden kann, wird ein umfassender Zugang zum Wärmetauscher 10, beispielsweise zu Reinigungszwecken, ermöglicht.

Fig. 3 zeigt die Lüftereinheit 24, welche in Querrichtung 7 in ein Einschubfach 8 des Schaltschranks eingeschoben werden kann. Gemäß dieser Ausführung umfasst die Lüftereinheit 24 mehrere Einzellüfter, welche über die Breite des Kühlkanals 22 bzw. des Auslasses 23 Luft 25 des Primärkühlkreislaufs 26 aus dem Kühlkanal 22 in den Innenraum 2 fördern. Die Ausbildung der Lüftereinheit 24 als Einschubbauteil hat zur Folge, dass bei einem Ausfall eines Einzellüfters in zeit-effizienter Weise ein Austausch der gesamten Lüftereinheit 24 vorgenommen werden kann. Dies ist von besonderer Wichtigkeit, wenn die Komponenten 3 in dem Schaltschrank 1 des Schienenfahrzeugs 100 zu Bereitstellung vitaler Funktionen des Schienenfahrzeugs 100 dienen, und ein langwieriger Austausch eines Lüfters der Primärkühlvorrichtung 20 zu einem lang andauernden Ausfall des gesamten Schienenfahrzeugs 100 führte.

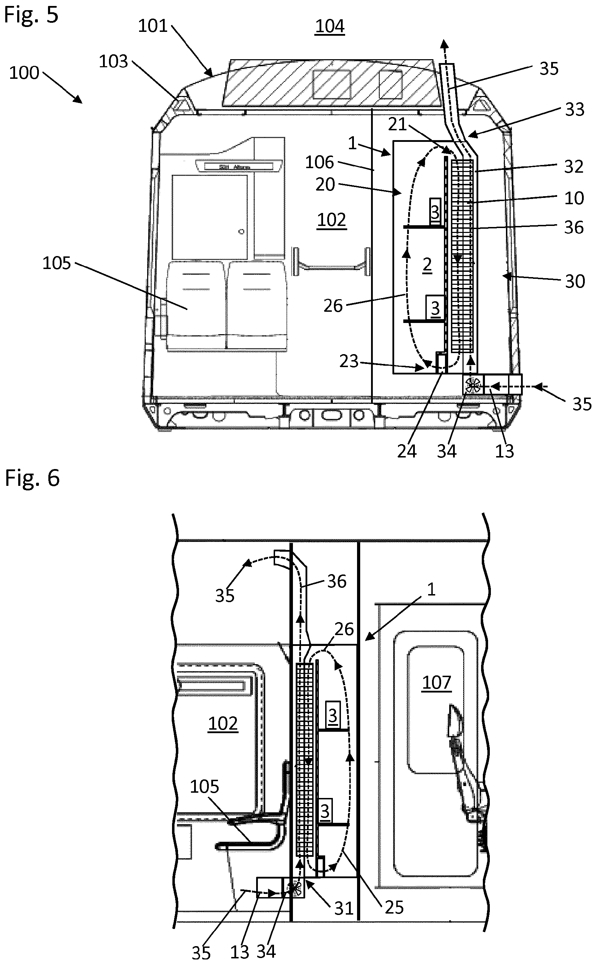

Der in Fig. 5 gezeigte Querschnitt dient zur Veranschaulichung eines Applikationsbeispiels des Schaltschranks 1 in einem Schienenfahrzeug. Die Aufstellung des Schaltschranks 1 ist dabei so gewählt, dass die Sekundärkühlvorrichtung 30 zu einer Außenwand 103 des Wagenkastens 101 gerichtet ist. Weiterhin sind in der Außenwand 103 des Wagenkastens 101 Luftkanäle zur Verbindung der Einströmöffnung 31 und der Ausströmöffnung 33 mit einer Außenumgebung 104 des Schienenfahrzeugs 100 verbaut. Über diese Luftkanäle wird Kühlluft 35 nach Passieren einer Filtervorrichtung 13 über ein Gebläse 34 in die Einströmöffnung 31 der Sekundärkühlvorrichtung 30 eingeblasen. Diese überströmt die Wärmequelle 12 des Wärmetauschers 10 und gelangt über die Ausströmöffnung 33 und einen dafür vorgesehenen Luftkanal wieder in die Außenumgebung 104.

Der Schaltschrank 1 ist in einem Bereich des Wagenkastens 101 angeordnet welche durch eine Innenwand 106 vom Fahrgastraum 102 abgetrennt ist. In der Innenwand 106 ist eine nicht dargestellte Klappe oder Tür vorgesehen, welche vom Fahrgastraum 102 aus von autorisiertem Personal geöffnet werden kann. Somit wird ein Zugang zum Schaltschrank 1 ermöglicht.

Eine weitere Applikationsmöglichkeit eines Schaltschranks 1 in einem Schienenfahrzeug 100 wird in Fig. 6 gezeigt. Der Längsschnitt durch das Schienenfahrzeug 100 zeigt in Anlehnung an Fig. 1 den Schaltschrank 1 im Bereich des Führerstands 107. Der Bereich des Schaltschranks 1 ist durch Innenwände 106 von dem Fahrgastraum 102 und Führerstand 107 abgetrennt, wobei der Innenraum 2 des Schaltschranks 1 vom Führerstand 107 her durch Verwendung einer nicht dargestellten Klappe oder Tür erreichbar ist.

Die Sekundärkühlvorrichtung 30 des Schaltschranks 1 bzw. die Rückseite 4 des Schaltschranks 1 ist dabei hin zum Fahrgastraum 102 orientiert. Dadurch kann die Innenwand 106 durch die Sekundärkühlvorrichtung 30 bzw. durch die Wärme der Wärmequelle 12 des Wärmetauschers 10 im Strömungskanal 32 angewärmt werden.

Die von der Sekundärkühlvorrichtung 30 benötigte Kühlluft 35 wird aus dem Fahrgastraum 102 über einen Kanal, einen Filter 13 und ein Gebläse 34 in die Einströmöffnung 31 der Sekundärkühlvorrichtung 30 geführt. Nachdem die Kühlluft 35 den Strömungskanal 32 passiert hat, gelangt sie über die Ausströmöffnung 33 und ein anschließendes Kanalsystem zurück in den Fahrgastraum 102. Die Abwärme des Schaltschranks 1 wird dabei genutzt um den Fahrgastraum 102 anzuwärmen.

Die Erfindung wird durch die angehängten Ansprüche definiert.

### Bezugszeichenliste

- 1: Schaltschrank
- 2: Innenraum
- 3: Wärme erzeugenden Komponente
- 4: Rückseite des Schaltschranks
- 5: Trennwand
- 6: Längsrichtung
- 7: Querrichtung
- 8: Einschubfach
- 9: Träger
- 10: Wärmetauscher
- 11: Wärmesenke
- 12: Wärmequelle
- 13: Filtervorrichtung
- 14: Gehäuse
- 15: Trennelement
- 16: Abdeckung
- 20: Primärkühlvorrichtung
- 21: Einlass
- 22: Kühlkanal
- 23: Auslass
- 24: Lüftereinheit
- 25: Luft
- 26: Primärkühlkreislauf
- 30: Sekundärkühlvorrichtung
- 31: Einströmöffnung
- 32: Strömungskanal
- 33: Ausströmöffnung
- 34: Gebläse
- 35: Kühlluft
- 36: Sekundarkühlkreislauf
- 100: Schienenfahrzeug
- 101: Wagenkasten
- 102: Fahrgastraum
- 103: Außenwand des Wagenkastens
- 104: Außenumgebung des Wagenkastens
- 105: Sitzvorrichtung
- 106: Innenwand
- 107: Führerstand
- 108: Bereich der Wagenkupplung

## Patentansprüche

1. Schaltschrank (1) für ein Fahrzeug, insbesondere Schienenfahrzeug (100), aufweisend
- einen Innenraum (2) zur Aufnahme mindestens einer Wärme erzeugenden Komponente (3),
- eine Primärkühlvorrichtung (20) mit einem Einlass (21), einem sich daran anschließenden Kühlkanal (22), einer im Kühlkanal (22) angeordneten Wärmesenke (11), und einem Auslass (23), wobei Einlass (21) und Auslass (23) mit dem Innenraum (2) strömungstechnisch verbunden sind, und somit die Primärkühlvorrichtung (20) und der Innenraum (2) einen in sich geschlossenen Primärkühlkreislauf (26) mit einem gasförmigen Kühlmedium, insbesondere Luft (25), bilden, wobei die Primärkühlvorrichtung (20) eine Lüftereinheit (24) zum Umwälzen des Kühlmediums aufweist,
- eine Sekundärkühlvorrichtung (30) mit einer Einströmöffnung (31), einem damit verbundenen und in eine Ausströmöffnung (33) mündenden Strömungskanal (32), und einer im Strömungskanal (32) angeordneten Wärmequelle (12),
- wobei die Wärmesenke (11) mit der Wärmequelle (12) zum Übertragen von Wärme von der Wärmesenke (11) auf die Wärmequelle (12) geeignet verbunden ist, sodass Wärmesenke (11) und Wärmequelle (12) einen Wärmetauscher (10) bilden,
- wobei die Primärkühlvorrichtung (20) und die Sekundärkühlvorrichtung (30) durch den Wärmetauscher (10) stofflich vollständig voneinander getrennt ausgebildet sind,
- wobei der Wärmetauscher (10) als räumlich trennendes Element zwischen dem Kühlkanal (22) und dem Strömungskanal (32) fungiert und zumindest teilweise als Trennwand (5) ausgebildet ist,
- wobei der Kühlkanal (22) und der Strömungskanal (32) direkt aneinander angrenzend angeordnet sind,
- wobei die Lüftereinheit (24) im Bereich des Auslasses (23) der Primärkühlvorrichtung (20) derart angeordnet ist, sodass Luft (25) durch den Kühlkanal (22) gesaugt und in den Innenraum (2) gepumpt werden kann.

2. Schaltschrank (1) nach Anspruch 1, wobei die Wärmesenke (11) und die Wärmequelle (12) körperlich miteinander verbunden oder einstückig ausgebildet sind.

3. Schaltschrank (1) nach Anspruch 2, wobei der Wärmetauscher (10) eine zweiseitige Rippen- oder Zackenstruktur aufweist, wobei eine erste Seite als Wärmesenke (11) und eine zweite Seite als Wärmequelle (12) fungiert.

4. Schaltschrank (1) nach einem der voran gestellten Ansprüche, wobei der Wärmetauscher (10) sich in einer Längsrichtung (6) über mindestens 50 %, bevorzugt 70 % und besonders bevorzugt 85 % der Länge des Kühlkanals (22) und/oder sich in einer Querrichtung (7) im Wesentlichen über die gesamte Breite des Kühlkanals (22) erstreckt.

5. Schaltschrank (1) nach einem der voran gestellten Ansprüche, wobei der Primärkühlkreislauf (26) und der Sekundärkühlkreislauf (36), die Dimension des Wärmetauschers (10), die Quantität der Wärmequellen im Innenraum (2) und die Volumina der Kühlmedien derart aufeinander abgestimmt sind, sodass in der Sekundärkühlvorrichtung (30) keine Lüftereinheit und/oder Gebläse vorgesehen ist/sind.

6. Schaltschrank (1) nach einem der voran gestellten Ansprüche 1 bis 4, wobei die Sekundärkühlvorrichtung (30) ein Gebläse (34) umfasst, welches wirksam stromaufwärts der Einströmöffnung (31), insbesondere in deren unmittelbarer Umgebung, oder stromabwärts der Ausströmöffnung (33), insbesondere in deren unmittelbarer Umgebung, der angeordnet ist.

7. Schaltschrank (1) nach einem der voran gestellten Ansprüche, wobei die Einströmöffnung (31) und die Ausströmöffnung (33) strömungstechnisch mit einer Umgebung des Schaltschranks (1) verbunden sind, und somit die Sekundärkühlvorrichtung (30) einen offenen Sekundärkühlkreislauf (36) aufweist.

8. Schaltschrank (1) nach einem der voran gestellten Ansprüche, wobei eine Filtervorrichtung (36) wirksam stromaufwärts der Einströmöffnung (31), insbesondere in deren unmittelbarer Umgebung, angeordnet ist.

9. Schaltschrank (1) nach einem der voran gestellten Ansprüche, wobei die Sekundärkühlvorrichtung (30) flächig an einer Rückseite (4) des Schaltschranks (1) ausgebildet ist.

10. Schaltschrank (1) nach einem der voran gestellten Ansprüche, wobei der Strömungskanal (32) eine demontierbare Abdeckung (16) derart aufweist, so dass der Wärmetauscher (10) zu Wartungszwecken erreichbar ist.

11. Schaltschrank (1) nach einem der voran gestellten Ansprüche, wobei, bezogen auf eine Montageposition des Schaltschranks (1), das Kühlmedium im Wesentlichen im Innenraum (2) von unten nach oben und im Kühlkanal (22) von oben nach unten strömt, und wobei insbesondere ein Kühlmedium der Sekundärkühlvorrichtung (30) im Strömungskanal (32) im Wesentlichen von unten nach oben strömt.

12. Fahrzeug, insbesondere Schienenfahrzeug (100), aufweisend einen Wagenkasten (101) mit einem Fahrgastraum (102) und einen Schaltschrank (1) nach einem der vorangestellten Ansprüche, wobei die Einströmöffnung (31) und/oder Ausströmöffnung (33) mit einer Außenumgebung (103) des Wagenkastens (101) und/oder mit dem Fahrgastraum (101) strömungstechnisch verbunden sind.

13. Fahrzeug nach Anspruch 12, wobei der Schaltschrank (1) derart im Wagenkasten (101) vorgesehen ist, sodass die Sekundärkühlvorrichtung (30) zwischen dem Innenraum (2) des Schaltschranks (1) und einer Außenwand (103) des Wagenkastens (101) oder zwischen dem Innenraum (2) des Schaltschrank (1) und dem Fahrgastraum (102) angeordnet ist.

## Claims

1. A control cabinet (1) for a vehicle, in particular a rail vehicle (100), comprising
- an interior space (2) for accommodating at least one heat-generating component (3),
- a primary cooling device (20) with an inlet (21), a cooling channel (22) adjoining thereto, a heat sink (11) arranged in the cooling channel (22), and an outlet (23), wherein the inlet (21) and the outlet (23) are fluidically connected to the interior space (2), and thus the primary cooling device (20) and the interior space (2) form a closed primary cooling circuit (26) with a gaseous coolant, in particular air (25), wherein the primary cooling device (20) has a fan unit (24) for circulating the coolant,
- a secondary cooling device (30) having an inlet opening (31), a flow channel (32) connected thereto and opening into an outlet opening (33), and a heat source (12) arranged in the flow channel (32),
- wherein the heat sink (11) is appropriately connected to the heat source (12) for transferring heat from the heat sink (11) to the heat source (12) such that the heat sink (11) and heat source (12) form a heat exchanger (10),
- wherein the primary cooling device (20) and the secondary cooling device (30) are completely materially separated from each other by the heat exchanger (10),
- wherein the heat exchanger (10) acts as a spatially separating element between the cooling channel (22) and the flow channel (32) and is formed at least partially as a partition wall (5),
- wherein the cooling channel (22) and the flow channel (32) are arranged directly adjacent to each other,
- wherein the fan unit (24) is arranged in the area of the outlet (23) of the primary cooling device (20) such that air (25) can be sucked through the cooling channel (22) and pumped into the interior space (2).

2. The control cabinet (1) according to claim 1, wherein the heat sink (11) and the heat source (12) are physically connected or integrally formed.

3. The control cabinet (1) according to claim 2, wherein the heat exchanger (10) has a two-sided fin or jag structure, wherein a first side acts as a heat sink (11) and a second side acts as a heat source (12).

4. The control cabinet (1) according to one of the preceding claims, wherein the heat exchanger (10) extends in a longitudinal direction (6) over at least 50%, preferably 70%, and particularly preferably 85% of the length of the cooling channel (22) and/or extends in a transverse direction (7) essentially over the entire width of the cooling channel (22).

5. The control cabinet (1) according to one of the preceding claims, wherein the primary cooling circuit (26) and the secondary cooling circuit (36), the dimension of the heat exchanger (10), the quantity of the heat sources in the interior space (2) and the volumes of the coolants are matched to one another such that no fan unit and/or fans is/are provided in the secondary cooling device (30).

6. The control cabinet (1) according to any one of the preceding claims 1 to 4, wherein the secondary cooling device (30) comprises a fan (34) which is effectively arranged upstream of the inlet opening (31), in particular in its immediate surrounding, or downstream of the outlet opening (33), in particular in its immediate surrounding.

7. The control cabinet (1) according to one of the preceding claims, wherein the inlet opening (31) and the outlet opening (33) are fluidically connected to an environment of the control cabinet (1), and thus the secondary cooling device (30) comprises an open secondary cooling circuit (36).

8. The control cabinet (1) according to any one of the preceding claims, wherein a filter device (36) is effectively arranged upstream of the inlet opening (31), in particular in its immediate surrounding.

9. The control cabinet (1) according to one of the preceding claims, wherein the secondary cooling device (30) is formed in a planar manner on a rear side (4) of the control cabinet (1).

10. The control cabinet (1) according to any one of the preceding claims, wherein the flow channel (32) comprises a removable cover (16) such that the heat exchanger (10) is accessible for maintenance purposes.

11. The control cabinet (1) according to one of the preceding claims, wherein, referring to a mounting position of the control cabinet (1), the coolant flows essentially from bottom to top in the interior space (2) and from top to bottom in the cooling channel (22), and wherein, in particular, a coolant of the secondary cooling device (30) flows essentially from bottom to top in the flow channel (32).

12. A vehicle, in particular a rail vehicle (100), comprising a railcar body (101) with a passenger compartment (102) and the control cabinet (1) according to one of the preceding claims, wherein the inlet opening (31) and/or outlet opening (33) are fluidically connected to an external environment (103) of the railcar body (101) and/or to the passenger compartment (101).

13. The vehicle according to claim 12, wherein the control cabinet (1) is provided in the railcar body (101) such that the secondary cooling device (30) is arranged between the interior space (2) of the control cabinet (1) and an outer wall (103) of the railcar body (101) or between the interior space (2) of the control cabinet (1) and the passenger compartment (102).

## Revendications

1. Armoire électrique (1) pour un véhicule, en particulier un véhicule ferroviaire (100), présentant
- un espace intérieur (2) permettant de loger au moins un composant générateur de chaleur (3),
- un dispositif de refroidissement primaire (20) comportant une entrée (21), un canal de refroidissement (22) relié à celle-ci, un dissipateur thermique (11) disposé dans le canal de refroidissement (22) et une sortie (23), l'entrée (21) et la sortie (23) étant reliées par liaison fluidique à l'espace intérieur (2), et le dispositif de refroidissement primaire (20) et l'espace intérieur (2) formant ainsi un circuit de refroidissement primaire (26) autonome comportant un milieu de refroidissement gazeux, en particulier de l'air (25), le dispositif de refroidissement primaire (20) présentant une unité de ventilateur (24) permettant de faire circuler le milieu de refroidissement,
- un dispositif de refroidissement secondaire (30) comportant une ouverture d'entrée (31), un canal d'écoulement (32) relié à celle-ci et débouchant dans une ouverture de sortie (33), et une source de chaleur (12) disposée dans le canal d'écoulement (32),
- le dissipateur thermique (11) étant relié de manière effective à la source de chaleur (12) pour transférer de la chaleur provenant du dissipateur thermique (11) à la source de chaleur (12), de sorte que le dissipateur thermique (11) et la source de chaleur (12) forment un échangeur de chaleur (10),
- le dispositif de refroidissement primaire (20) et le dispositif de refroidissement secondaire (30) étant formés de manière à être matériellement complètement séparés l'un de l'autre par l'échangeur de chaleur (10),
- l'échangeur de chaleur (10) agissant comme un élément de séparation spatiale entre le canal de refroidissement (22) et le canal d'écoulement (32), et étant au moins partiellement conçu comme une cloison (5),
- le canal de refroidissement (22) et le canal d'écoulement (32) étant disposés directement adjacents l'un à l'autre,
- l'unité de ventilateur (24) étant disposée dans la zone de la sortie (23) du dispositif de refroidissement primaire (20) de sorte que de l'air (25) peut être aspiré à travers le canal de refroidissement (22) et pompé dans l'espace intérieur (2).

2. Armoire électrique (1) selon la revendication 1, dans laquelle le dissipateur thermique (11) et la source de chaleur (12) sont physiquement reliés l'un à l'autre ou sont formés d'une seule pièce.

3. Armoire électrique (1) selon la revendication 2, dans laquelle l'échangeur de chaleur (10) présente une structure nervurée ou dentelée à deux côtés, un premier côté agissant comme un dissipateur de chaleur (11) et un second côté agissant comme une source de chaleur (12).

4. Armoire électrique (1) selon l'une des revendications précédentes, dans laquelle l'échangeur de chaleur (10) s'étend dans une direction longitudinale (6) sur au moins 50 %, de préférence 70 %, et de manière particulièrement préférée 85 % de la longueur du canal de refroidissement (22) et/ou s'étend dans une direction transversale (7) sensiblement sur toute la largeur du canal de refroidissement (22).

5. Armoire électrique (1) selon l'une des revendications précédentes, dans laquelle le circuit de refroidissement primaire (26) et le circuit de refroidissement secondaire (36), les dimensions de l'échangeur de chaleur (10), la quantité des sources de chaleur dans l'espace intérieur (2) et les volumes des milieux de refroidissement sont coordonnés les uns avec les autres de telle sorte qu'aucune unité de ventilateur et/ou soufflante ne sont agencées dans le dispositif de refroidissement secondaire (30).

6. Armoire électrique (1) selon l'une des revendications précédentes 1 à 4, dans laquelle le dispositif de refroidissement secondaire (30) comprend une soufflante (34) qui est disposée de manière opérationnelle en amont de l'ouverture d'arrivée (31), en particulier dans l'environnement immédiat de celle-ci, ou en aval de l'ouverture de sortie (33), en particulier dans l'environnement immédiat de celle-ci.

7. Armoire électrique (1) selon l'une des revendications précédentes, dans laquelle l'ouverture d'entrée (31) et l'ouverture de sortie (33) sont reliées par liaison fluidique à un environnement de l'armoire électrique (1), et le dispositif de refroidissement secondaire (30) présente ainsi un circuit de refroidissement secondaire (36) ouvert.

8. Armoire électrique (1) selon l'une des revendications précédentes, dans laquelle un dispositif de filtrage (36) est disposé de manière opérationnelle en amont de l'ouverture d'entrée (31), en particulier dans l'environnement immédiat de celle-ci.

9. Armoire électrique (1) selon l'une des revendications précédentes, dans laquelle le dispositif de refroidissement secondaire (30) est conçu à plat sur un côté arrière (4) de l'armoire électrique (1).

10. Armoire électrique (1) selon l'une des revendications précédentes, dans laquelle le canal d'écoulement (32) présente un couvercle amovible (16) de telle sorte que l'échangeur de chaleur (10) est accessible à des fins de maintenance.

11. Armoire électrique (1) selon l'une des revendications précédentes, dans laquelle, en fonction d'une position de montage de l'armoire électrique (1), le milieu de refroidissement s'écoule sensiblement de bas en haut dans l'espace intérieur (2) et de haut en bas dans le canal de refroidissement (22), et dans lequel en particulier un milieu de refroidissement du dispositif de refroidissement secondaire (30) s'écoule sensiblement de bas en haut dans le canal d'écoulement (32).

12. Véhicule, en particulier véhicule ferroviaire (100), présentant une caisse de wagon (101) comportant un habitacle (102) et une armoire électrique (1) selon l'une des revendications précédentes, l'ouverture d'entrée (31) et/ou l'ouverture de sortie (33) étant reliées par liaison fluidique avec un environnement extérieur (103) de la caisse de wagon (101) et/ou avec l'habitacle (101).

13. Véhicule selon la revendication 12, dans lequel l'armoire électrique (1) est agencée dans la caisse de wagon (101) de telle sorte que le dispositif de refroidissement secondaire (30) est disposé entre l'espace intérieur (2) de l'armoire électrique (1) et une paroi extérieure (103) de la caisse de wagon (101) ou entre l'espace intérieur (2) de l'armoire électrique (1) et l'habitacle (102).
